# EUROPÄISCHE PATENTANMELDUNG

(11) **EP 3 258 515 A1**
(43) Veröffentlichungstag der Anmeldung: **20.12.2017**
(21) Anmeldenummer: 16174537.7
(22) Anmeldetag: 15.06.2016
(51) Int. Cl.: H01L 51/52

(54) **LEUCHTEINHEIT MIT ORGANISCHER LEUCHTDIODE (OLED) FÜR FAHRZEUGANWENDUNGEN SOWIE VERFAHREN ZU DEREN HERSTELLUNG**

(71) Anmelder: odelo GmbH, 70329 Stuttgart (DE)
(72) Erfinder: VOLLMER, Marco, 71332 Waiblingen (DE); GAUCH, Winfried, 71106 Magstadt (DE)
(74) Vertreter: Benninger, Johannes

(57) **Zusammenfassung**

Es werden eine Leuchteinheit 01) mit mindestens einer OLED (02) mit einer ersten, vorder- und rückseitigen Verkapselung (03) und mit einer zweite Verkapselung (04) zumindest an den Vorderseite (11) und Rückseite (12) miteinander verbindenden Schmalseiten (05), sowie ein Verfahren zur Herstellung einer solchen Leuchteinheit (01) beschrieben. Das Verfahren sieht die folgenden Verfahrensschritte vor:
- Bereitstellung einer OLED (02) mit einer ersten, vorder- und rückseitigen Verkapselung (03),
- Schablonierung der OLED (02) unter Maskierung zumindest eines Teils der ersten Verkapselung (03), und
- Aufbringen der zweiten Verkapselung (04) unter Freilassung des bei der Schablonierung maskierten Teils der ersten Verkapselung (03) von der zweiten Verkapselung (04).

## Beschreibung

Die Erfindung betrifft eine Leuchteinheit mit mindestens einer organischen Leuchtdiode gemäß dem Oberbegriff des Anspruchs 1 sowie ein Verfahren zur Herstellung einer solchen Leuchteinheit gemäß dem Oberbegriff des Anspruchs 13.

Aufgrund ihres hohen Wirkungsgrads bei der Umwandlung von elektrischem Strom in für das menschliche Auge sichtbares Licht kommen als Lichtquellen von Leuchtmitteln für Fahrzeugleuchten vermehrt anorganische Leuchtdioden zum Einsatz. Organische Leuchtdioden versprechen die selben Vorteile, jedoch steht deren Serieneinsatz bislang deren bei Fahrzeuganwendungen zu geringe Lebensdauer entgegen.

Eine kurz als OLED (Organic Light Emitting Diode; OLED) bezeichnete organische Leuchtdiode ist ein leuchtendes Dünnschichtbauelement aus organischen halbleitenden Materialien mit mindestens einer zwischen elektrisch leitenden, beispielsweise metallischen Schichten für Anode und Kathode eingeschlossen Emitterschicht. Die Stärke oder anders ausgedrückt Dicke der Schichten liegt in einer Größenordnung von etwa 100 nm. Typischerweise beträgt sie je nach Aufbau 100 nm bis 500 nm.

Im Unterschied zu anorganischen Leuchtdioden benötigen OLEDs keine einkristallinen Materialien. Im Vergleich zu anorganischen Leuchtdioden lassen sich OLEDs daher in kostengünstiger Dünnschichttechnik herstellen. OLEDs ermöglichen dadurch die Herstellung flächiger Lichtquellen, die einerseits sehr dünn und andererseits als leuchtende Fläche eingesetzt einen besonders homogenes Erscheinungsbild aufweisen.

Zum Schutz gegen Wasser, Sauerstoff sowie zum Schutz gegen andere Umwelteinflüsse, wie etwa Kratzbeschädigung und/oder Druckbelastung sind OLEDs typischerweise mit einem anorganischen Material insbesondere mit Glas verkapselt. Eine effektive Verkapselung gegenüber Sauerstoff und Wasser zu einem Substrat hin, auf dem die eigentliche OLED einschließlich deren einer oder mehreren Emitterschichten Schicht um Schicht aufgebaut ist, geschieht durch eine Dünnglas-Schicht im oder auf dem Substrat.

Zwar gibt es Anstrengungen, das Glas durch Kunststoff zu ersetzen, die jedoch insbesondere um beispielsweise die Lebensdaueranforderung von Fahrzeugleuchten und deren Lichtquellen mit mehreren 1000 Stunden hinreichend gut zu erfüllen noch nicht vom gewünschten Erfolg gekrönt sind, weil die Dichtigkeit der alternativen Materialien für die Verkapselung nicht ausreichend gut genug ist.

OLEDs weisen insbesondere bei Fahrzeuganwendungen eine nur begrenzte Lebensdauer auf. Diese ist geringer, als beispielsweise in Verbindung mit einer Verwendung als Lichtquelle eines zur Erfüllung beispielsweise einer Schlusslichtfunktion vorgesehenen Leuchtmittels geforderten Mindestlebensdauer von 8000 Betriebsstunden im eingeschalteten Zustand.

Die Lebensdauer von OLEDs wird unter anderem durch auftretende Wärmebelastungen und durch Diffusionsprozesse durch sowie Schad- und Schwachstellen in deren Verkapselung herabgesetzt.

Um dennoch OLEDs für Fahrzeuganwendungen vorsehen zu können steht die Möglichkeit zur Verfügung, diese niedriger zu bestromen und damit deren Leuchtdichte zu verringern um elektrische, thermische, und weitere Belastungen der OLED geringer zu halten. Ansonsten muss eine geringere Lebensdauer bei höheren Strom- und Leuchtdichten in Kauf genommen werden. Zusätzliche Möglichkeiten sind eine Vergrößerung der effektiv beispielsweise von außerhalb einer Fahrzeugleuchte sichtbare OLED-Leuchtfläche einhergehend mit einer Verminderung der Abschattung von OLEDs, sei dies gegenseitig und/oder durch Blenden.

Vor allem hohe Temperaturen führen zu einer schnell voranschreitende Alterung der OLEDs. Mit zunehmender Alterung steigt die Vorwärtsspannung irreversibel und stark an, wobei sich gleichzeitig die Leuchtdichte sich bei gleichbleibender, konstanter Bestromung irreversibel verringert. Dies führt zu unerwünschten Effekten, wie etwa einer geringeren Effizienz der OLEDs und einem damit einhergehenden höheren Temperatureintrag durch Abwärme in die Fahrzeugleuchte.

Auch werden die organischen Materialien ab einer bestimmten hohen Temperatur vollständig oder weitestgehend vollständig zerstört, so dass diese nicht mehr wie vorgesehen zum Leuchten der Emitterschicht angeregt werden können. Dies erfolgt ab Temperaturen von etwa 105°C und höher.

Weiterhin erreichen OLEDs für einzelne Lichtfunktionen noch nicht ausreichend hohe Leuchtdichten über einen längeren Zeitraum, so dass sie beispielsweise für Rückfahrscheinwerferlichtfunktionen oder Bremslichtfunktionen noch nicht sinnvoll eingesetzt werden können.

Eine weitere Herausforderung stellt für die OLEDs der Einfluss von durch Wasser, Wasserdampf, Wassermoleküle gebildete Feuchtigkeit dar. Dieser sorgt insbesondere in Kombination mit hohen Temperaturen dazu, dass durch Fehlstellen in der Verkapselung und/oder Versiegelung der OLED an die organischen Schichten unter Anderem Wassermoleküle gelangen können, welche die organischen Schichten irreversibel schädigen und zu einem Ausfall oder Teilausfall der Emitterschicht führen. Dies lässt sich auch in die Lebensdauer für Bauteile in Fahrzeuganwendungen abbildenden Versuchen nachstellen. Bei einem Test eines solchen Versuchs wird die mit einem Leuchtmittel mit mindestens einer OLED als Lichtquelle ausgestattete Fahrzeugleuchte einer 85°C warmen Umgebungstemperatur und einer relativen Luftfeuchte von 85% über mehrere Stunden ausgesetzt. Hierbei zeigen sich bei unzureichender Verkapselung "Dark Spots" genannte dunkle Flecken oder Punkte in der leuchtenden Fläche die aufgrund der an Verkapselungsfehlstellen hindurchdiffundierenden/hindurch gelangenden Wassermoleküle auftreten. Da diese aufgrund der Verkapselungsfehlstellen auftreten kann dort mit der Zeit immer mehr Wasser hindurchgelangen und dadurch wächst und/oder vergrößert sich der "Dark Spot" mit der Zeit.

Nach aktuellen Erkenntnissen weisen OLEDs für fahrzeuganwendungsspezifische Betriebsbedingungen von beispielsweise -40°C... +80°C sowie einem zusätzlichem Einfluss von Luftfeuchtigkeit ein signifikantes Risiko aus, dass diese die geforderten Lebensdaueranforderungen nicht ausreichend erfüllen. Damit weisen sie für einen Serien-, insbesondere Großserieneinsatz ein nicht akzeptables Ausfallrisiko auf. Dies kann vor allem auf eine unzureichende Verkapselung der organischen Schichten zurückgeführt werden.

Daher werden unterschiedliche Anstrengungen unternommen, um die Verkapselung zu verbessern sowie die Fremdpartikelbelastung der Schichten zu minimieren, damit die Verkapselung eine größtmögliche Wassersperrfunktionalität über die gesamte Lebensdauer der OLED aufweist.

Es gibt auch OLED-Aufbauten bei dem ein so genanntes Getter-Material in der Nähe des organischen Materials angebracht wird. Dieses Material nimmt die eindringende oder schon vorhandene Restfeuchte auf und schützt so die Organik vor schädlichem Wasser. Dieser Aufbau ist aus OLED-Aufbauten mit entsprechend ausgehöhltem Kavitätsglas bekannt. Problematisch ist, dass das Getter-Material mit der Zeit von der Feuchtigkeit gesättigt wird und dann die Organik nicht mehr vor weiterer Feuchte schützen kann. Auch benötigt das Getter-Material zusätzlichen Platz und Raum in einer OLED. Die OLEDs sind aufwendiger in der Herstellung und dicker als ohne Getter-Material. Diese Technologie wird aktuell für OLEDs in Fahrzeuganwendungen nicht mehr bevorzugt.

Aktuell ist das Problem der Verkapselung noch nicht ausreichend gut gelöst und der Bedarf einer enormen Verbesserung vorhanden, um die Risiken für OLED-Leuchten mit hohen Stückzahlen ausreichend gering zu halten.

Durch DE 10 261 609 A1 ist eine OLED bekannt, deren organische Schichtfolge durch eine Dünnglas-Schicht gegenüber Sauerstoff und Wasser abgedichtet ist.

Durch DE 10 359 156 A1 ist eine OLED bekannt, deren mindestens eine organische Schicht mit einem Glasplättchen oder einer durch Bedampfung hergestellten Glasschicht vor Umwelteinflüssen geschützt ist.

Durch DE102005002837A1 ist eine OLED mit einem Getter-Material bekannt.

Durch DE 10 2012 211 335 A1 ist bekannt, die fortschreitende Abnahme der Wirkung eines Getter-Materials durch Farbveränderung sichtbar zu machen.

Zusammengefasst ist dem allgemeinen Stand der Technik eine Verkapselung von OLEDs mit Dünnglas-Schichten, beispielsweise in Form von Glasplättchen, oder durch Bedampfen aufgebrachtes Glas zu entnehmen. Hinsichtlich metallischer Substanzen in Verbindung mit einer Verkapselung handelt es sich um Gettermaterialien, deren Wasseraufnahmefähigkeit makroskopisch anhand deren Farbe erkennbar ist.

Eine Aufgabe der Erfindung ist es, eine als Lichtquelle insbesondere in Fahrzeuganwendungen verwendbare Leuchteinheit mit mindestens einer OLED zu schaffen, welche bei in Fahrzeuganwendungen herrschenden oder auftretenden oder zu ertragenden Umgebungsbedingungen eine gesteigerte Lebensdauer aufweist.

Ebenfalls eine Aufgabe der Erfindung ist es, ein Verfahren zur Herstellung einer als Lichtquelle insbesondere in Fahrzeuganwendungen verwendbare Leuchteinheit mit mindestens einer OLED anzugeben, welche bei in Fahrzeuganwendungen herrschenden oder auftretenden oder zu ertragenden Umgebungsbedingungen eine gesteigerte Lebensdauer aufweist.

Die Aufgabe wird jeweils durch die Merkmale der unabhängigen Ansprüche gelöst. Vorteilhafte Ausführungsformen sind in den Ansprüchen, den Zeichnungen sowie in der nachfolgenden Beschreibung, einschließlich der zu den Zeichnungen zugehörigen, wiedergegeben.

Ein erster Gegenstand der Erfindung betrifft demnach eine Leuchteinheit mit mindestens einer OLED mit einer ersten, vorder- und rückseitigen Verkapselung.

Die Leuchteinheit zeichnet sich durch eine zweite Verkapselung zumindest an den vor allem entlang von Vorder- und Rückseite miteinander verbindender schmalseitiger Rändern befindlicher Schwachstellen der ersten Verkapselung aus.

Es ist ersichtlich, dass die Erfindung durch eine OLED mit einer Verkapselung sowie mit einer Zusatzverkapselung verwirklicht sein kann.

Um dem Einfluss von Diffusionsprozessen durch die Verkapselung hindurch sowie Schad- und Schwachstellen in der Verkapselung zu begegnen, sieht die Erfindung eine zusätzliche, eine bestehende erste Verkapselung zumindest teilweise, vorzugsweise zumindest an deren Schwachstellen umgebende, kurz als Zusatzverkapselung bezeichnete zweite Verkapselung vor.

Bei der ersten Verkapselung handelt es sich um vorder- und rückseitige Schichten, beispielsweise Dünnglas-Schichten, Glasplättchen, die in einem um die OLED umlaufenden Randbereich aneinander anhaften.

Aufgrund der flächigen Struktur der Dünnglas-Schicht ist eine entsprechend wirksame Verkapselung nur vorder- und rückseitig möglich. Die Vorder- und Rückseite verbindenden Schmalseiten bleiben Schwachstellen der ersten Verkapselung.

Die zweite Verkapselung besteht bevorzugt aus einer oder mehreren metallischen Schichten, die beispielsweise durch Sputtern oder Bedampfen aufgebracht sein können.

Bevorzugt umfasst die erste Verkapselung ein Glasplättchen zumindest auf der zur Lichtabstrahlung vorgesehenen Vorderseite der OLED. In diesem Fall sieht die zweite Verkapselung eine Beschichtung:
- eines um das Glasplättchen umlaufenden Randbereichs,
- der die Vorder- und die Rückseite der die OLED beherbergenden ersten Verkapselung verbindenden Schmalseiten, sowie
- der Rückseite der OLED
vor.

Die erste Verkapselung kann zusätzlich zu einem Glasplättchen auf der zur Lichtabstrahlung vorgesehenen Vorderseite der OLED ein Glasplättchen auf der der Vorderseite abgewandten, durch die Schichten der OLED von der Vorderseite getrennten, gegenüberliegenden Rückseite umfassen. In diesem Fall sieht die zweite Verkapselung ebenfalls eine Beschichtung:
- eines um das Glasplättchen umlaufenden Randbereichs,
- der die Vorder- und die Rückseite der die OLED beherbergenden ersten Verkapselung verbindenden Schmalseiten, sowie
- der Rückseite der OLED
vor.

OLEDs für Fahrzeuganwendungen weisen wegen der hohen Sperrwirkung gegen Wasser bevorzugt Glas als Substratmaterial auf. Da Glas eine sehr gute Sperre gegen eindringendes Wasser ist, werden sämtliche Schichten für die OLED hierauf aufgebracht.

Der auch als Dampfsperrwert bezeichnete Wasserdampfdiffusionswiderstand drückt aus, wie stark ein Werkstoff die Ausbreitung von Wasserdampf durch Diffusion durch den Werkstoff hindurch verhindert. Er wird mittels der Wasserdampfdiffusionswiderstandszahl angegeben.

Glas hat ebenso wie Metalle einen sehr hohen Wasserdampfdiffusionswiderstand.

Demgegenüber weisen umgangssprachlich als Kunststoffe bezeichnete Polymere eine relativ hohe Wasserdampfdurchlässigkeit auf, d. h. sie haben eine geringe Sperrwirkung gegenüber Wasser, Wasserdampf. Nachdem Metalle für elektromagnetische Wellen im für das menschliche Auge sichtbaren Teil des Spektrums elektromagnetischer Wellen weitgehend intransparent sind, wird bevorzugt Glas als Substratmaterial für OLEDs verwendet. Eine Eigenschaft, die ebenfalls für die Verwendung von Glas anstelle von Metallen als Substrat spricht ist, dass die Oberfläche von Glas mit einer geringeren Rauheit hergestellt werden kann, was für die dünnen Schichten, die bei einer OLED darauf aufgebracht werden, wichtig ist, um eine gleichmäßige Schichtdicke, sowie einen planen und parallelen Schichtverlauf zu erhalten.

Auf der gegenüberliegenden Außenseite der OLED kann auch ein Glasplättchen als Glasdeckel aufgebracht werden. Die dazwischenliegenden Schichten, insbesondere die organischen Schichten, haben eine Schichtdicke von nur einigen 100nm bis hin zu wenigen µm. Folglich ist die Schwachstelle für eindringende Feuchtigkeit in der Hauptsache der Bereich zwischen den zwei Glasflächenrändern. Dieser Bereich wird vorzugsweise mit entsprechend gutem Material, insbesondere Kleber, versehen, so dass die zwei Glasplättchen in dem Bereich zwischen den zwei Glasflächenrändern aufeinander kleben und die innenliegenden Schichten relativ gut gegen Wasser und andere für die Schichten schädliche Stoffe geschützt sind, wie etwa Sauerstoff, Schwefelverbindungen. Dennoch ist dieser Bereich für eindringendes Wasser die Schwachstelle des OLED-Aufbaus.

Die eine oder mehreren OLEDs der Leuchteinheit können beispielsweise ein Glasplättchen mit aufgebrachter Indium-Zinn-Oxid (ITO; Indium Tin Oxide) Schicht als Substrat, hierauf aufgebrachten organischen und weiteren Schichten, insbesondere Dünnschichtverkapselung (TFE; Thin Film Encapsulation) und Hartschicht zum Schutz der TFE und hierauf eine aufgeklebte und/oder auflaminierte Aluminiumschicht beziehungsweise Alufolie umfassen.

Die Alufolie dient der besseren Wärmeableitung von der OLED weg. Diese vermeidet einen Wärmestau an der OLED. Darüber hinaus dient die Alufolie einer besseren Wärmeverteilung an der OLED. Durch die gleichmäßige Verteilung der Wärme an der OLED werden so genannte Hot Spots vermieden und dadurch ungleichmäßige Alterungserscheinungen aufgrund unterschiedlicher Temperatureinflüsse verringert.

Eine ungleichmäßige Alterungserscheinung führt zu Inhomogenitäten der Leuchtdichten innerhalb einer durch die von der mindestens einen Emitterschicht der OLED eingenommenen Leuchtfläche und/oder zu einer höheren Wahrscheinlichkeit einer Beschädigung der OLED, beispielsweise einem Teilausfall und/oder Frühausfall der OLED während deren Betriebs. Auch kann dies beim Einsatz von mehreren OLEDs und/oder Leuchteinheiten in einer Fahrzeugleuchte aufgrund einer dort herrschenden, nicht gleichmäßigenen Wärmeverteilung, zu sichtbaren Leuchtdichteunterschieden zwischen den OLEDs führen.

Die Alufolie kann alternativ oder zusätzlich auch außen auf ein zweites Glasplättchen der ersten Verkapselung aufgebracht werden.

Die Beschichtung der zweiten Verkapselung kann die Funktion einer beispielsweise metallischen Schicht zur Wärmespreizung übernehmen, wodurch auf eine entsprechende metallische Schicht in der OLED verzichtet werden kann.

Ein zweiter Gegenstand der Erfindung betrifft ein Verfahren zur Herstellung einer zuvor beschriebenen Leuchteinheit.

Das Verfahren sieht zunächst die Bereitstellung mindestens einer OLED mit einer ersten, vorder- und rückseitigen Verkapselung vor.

Anschließend sieht das Verfahren eine Schablonierung der mindestens einen OLED unter Maskierung zumindest eines eine in ihrer Ausdehnung der von einer Emitterschicht der OLED eingenommenen Fläche entsprechenden Leuchtfläche auf der zur Lichtabstrahlung vorgesehenen Vorderseite der OLED einnehmenden Teils der ersten Verkapselung vor.

Schließlich sieht das Verfahren ein Aufbringen der zweiten Verkapselung unter Freilassung des bei der Schablonierung maskierten Teils der ersten Verkapselung von der zweiten Verkapselung vor.

Vorteile gegenüber dem Stand der Technik sind eine Verbesserung der Kapselung organischer Leuchtdioden gegen das Eindringen schädlichen Wasserdampfs und Sauerstoffs einhergehend mit einer Erhöhung deren Lebensdauer insbesondere bei Fahrzeuganwendungen.

Zusätzliche, über die vollständige Lösung der gestellten Aufgabe und/oder über die voran zu den einzelnen Merkmalen genannten Vorteile hinausgehende Vorteile gegenüber dem Stand der Technik sind:
- Neue Designmöglichkeiten bei Fahrzeugleuchten
- Höhere Lebensdauer der OLEDs
- Ein verringertes Ausfallrisiko.

Die Leuchteinheit kann einzelne oder eine Kombination der zuvor und/oder nachfolgend in Verbindung mit dem Verfahren beschriebene Merkmale aufweisen, ebenso wie das Verfahren einzelne oder eine Kombination mehrerer zuvor und/oder nachfolgend in Verbindung mit der Leuchteinheit beschriebene Merkmale aufweisen und/oder verwirklichen kann.

Darüber hinaus kann die Leuchteinheit ebenso wie das Verfahren alternativ oder zusätzlich einzelne oder eine Kombination mehrerer einleitend in Verbindung mit dem Stand der Technik und/oder in einem oder mehreren der zum Stand der Technik erwähnten Dokumente und/oder in der nachfolgenden Beschreibung zu den in den Zeichnungen dargestellten Ausführungsbeispielen beschriebene Merkmale aufweisen oder verwirklichen.

Die Erfindung wird nachfolgend anhand von in der Zeichnung dargestellter Ausführungsbeispiele näher erläutert. Die Größenverhältnisse der einzelnen Elemente zueinander in den Figuren entsprechen nicht immer den realen Größenverhältnissen, da einige Formen vereinfacht und andere Formen zur besseren Veranschaulichung vergrößert im Verhältnis zu anderen Elementen dargestellt sind. Für gleiche oder gleich wirkende Elemente der Erfindung werden identische Bezugszeichen verwendet. Ferner werden der Übersicht halber nur Bezugszeichen in den einzelnen Figuren dargestellt, die für die Beschreibung der jeweiligen Figur erforderlich sind. Die dargestellten Ausführungsformen stellen lediglich Beispiele dar, wie die Erfindung ausgestaltet sein kann und stellen keine abschließende Begrenzung dar. Es zeigen in schematischer Darstellung:
- Fig. 1: eine Leuchteinheit mit einer OLED mit aufgebrachter Zusatzversiegelung in perspektivischer Vorderansicht.
- Fig. 2: eine Leuchteinheit mit einer mittels aufgebrachter Zusatzversiegelung versiegelten OLED in perspektivischer Rückansicht.
- Fig. 3: eine Leuchteinheit mit einer mittels aufgebrachter Zusatzversiegelung auch an ihren Schwachstellen versiegelten OLED in einer Draufsicht.
- Fig. 4: eine Leuchteinheit mit einer mittels aufgebrachter Zusatzversiegelung auch an ihren Schwachstellen versiegelten OLED in perspektivischer Vorderansicht.
- Fig. 5: eine Leuchteinheit mit einer mittels aufgebrachter Zusatzversiegelung auch an ihren Schwachstellen versiegelten OLED in einer weiteren perspektivischen Vorderansicht.
- Fig. 6: eine perspektivische Ansicht einer Leuchteinheit mit aufgebrachter Zusatzversiegelung und durchgehender Platine.
- Fig. 7: eine Leuchteinheit mit einer mittels aufgebrachter Zusatzversiegelung auch an ihren Schwachstellen versiegelten OLED, jedoch ohne elektrische Kontaktierung, in perspektivischer Vorderansicht.
- Fig. 8: eine Leuchteinheit mit Zusatzversiegelung ohne elektrische Kontaktierung in perspektivischer Vorderansicht.
- Fig. 9: einen Ablauf eines zur Herstellung einer in Fig. 1 bis Fig. 8 gezeigten Leuchteinheit geeigneten Verfahrens.

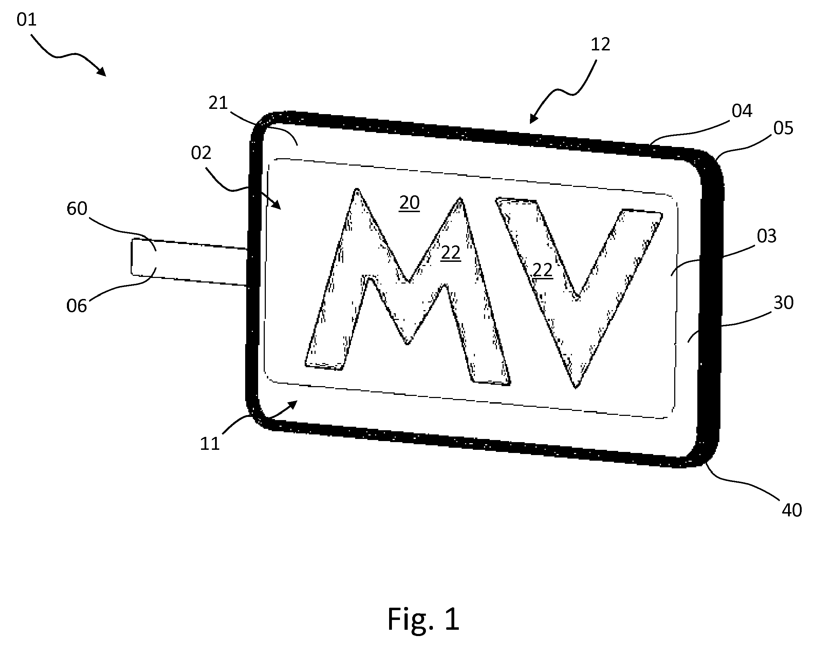

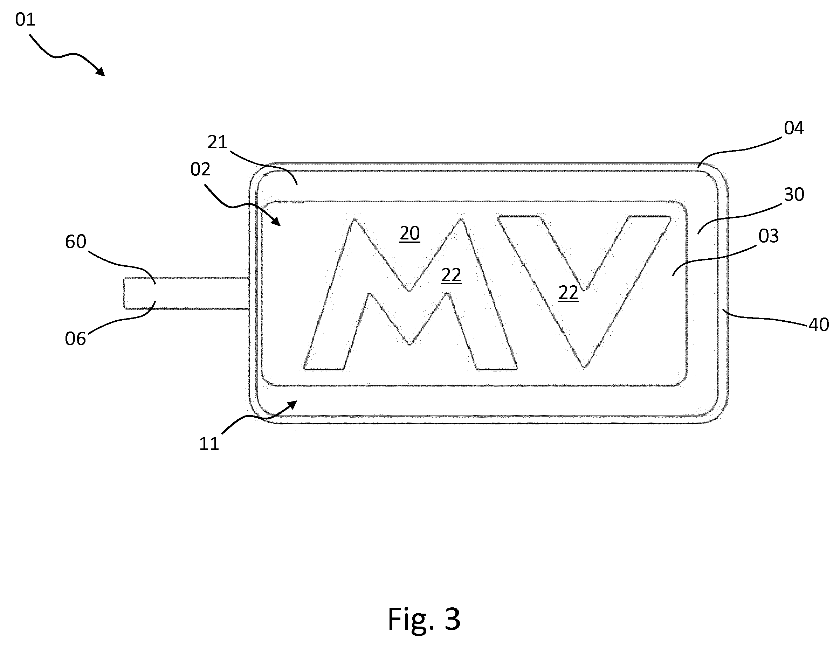

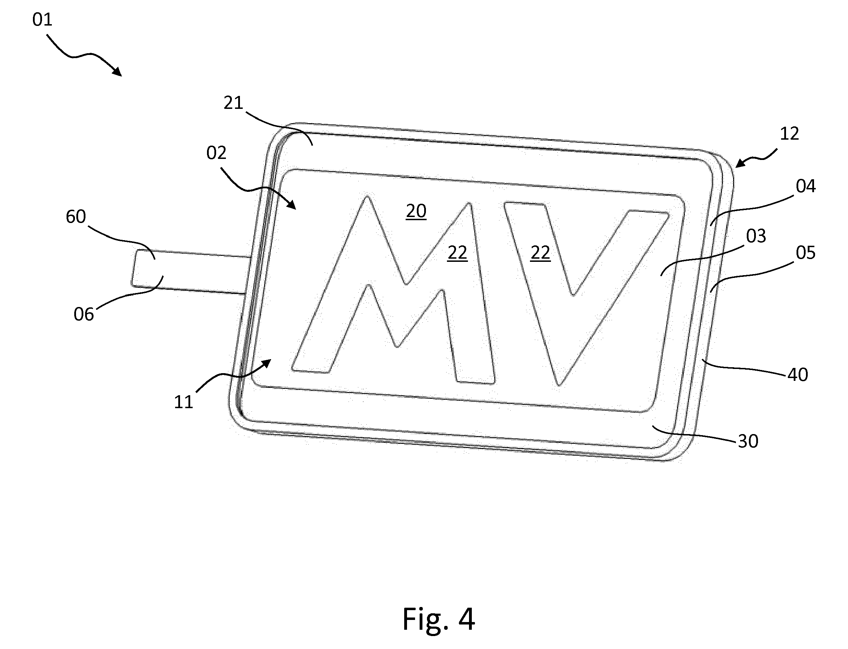

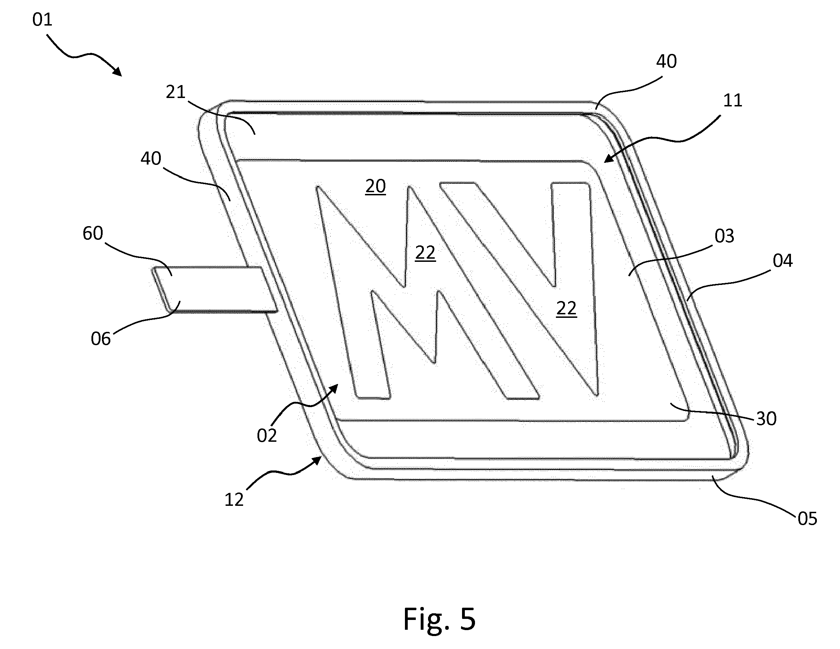

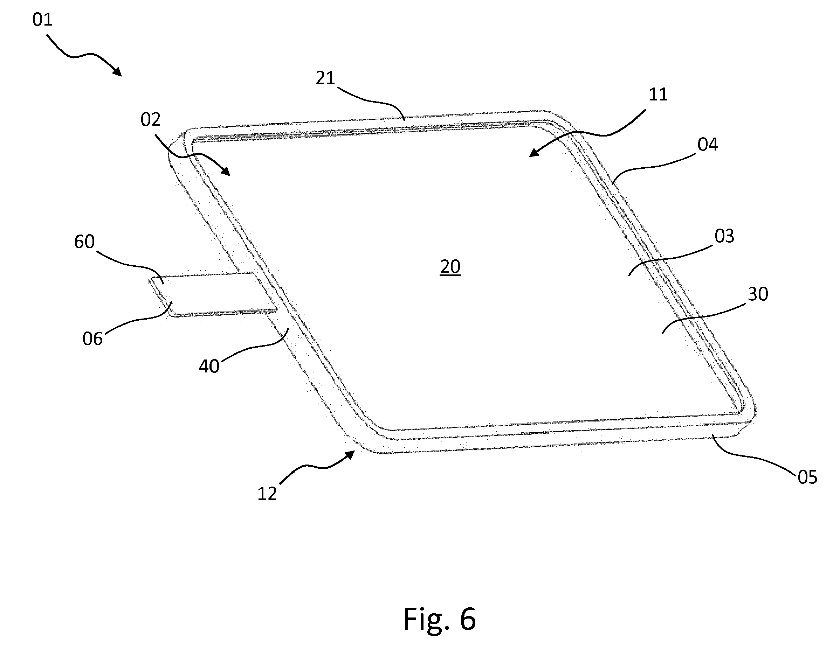

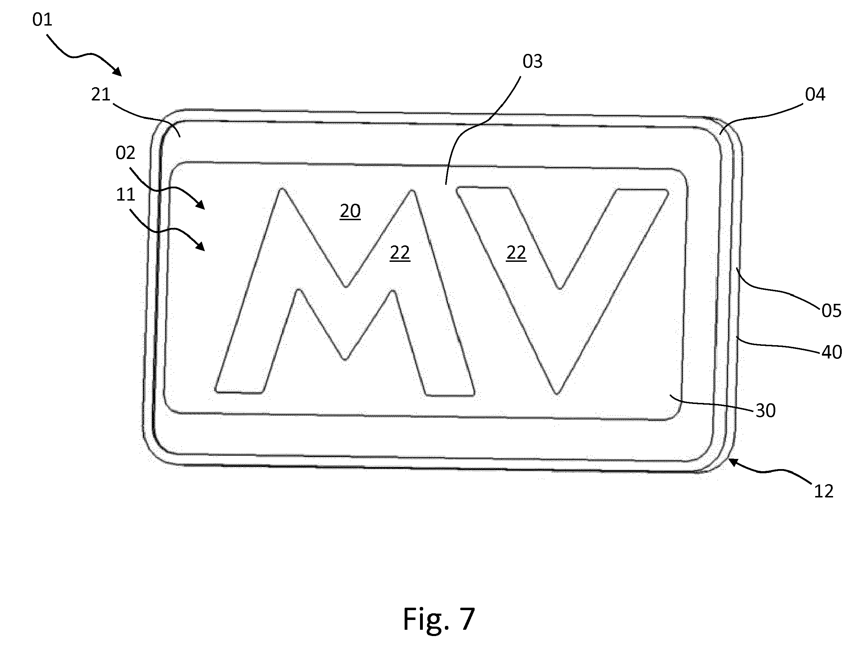

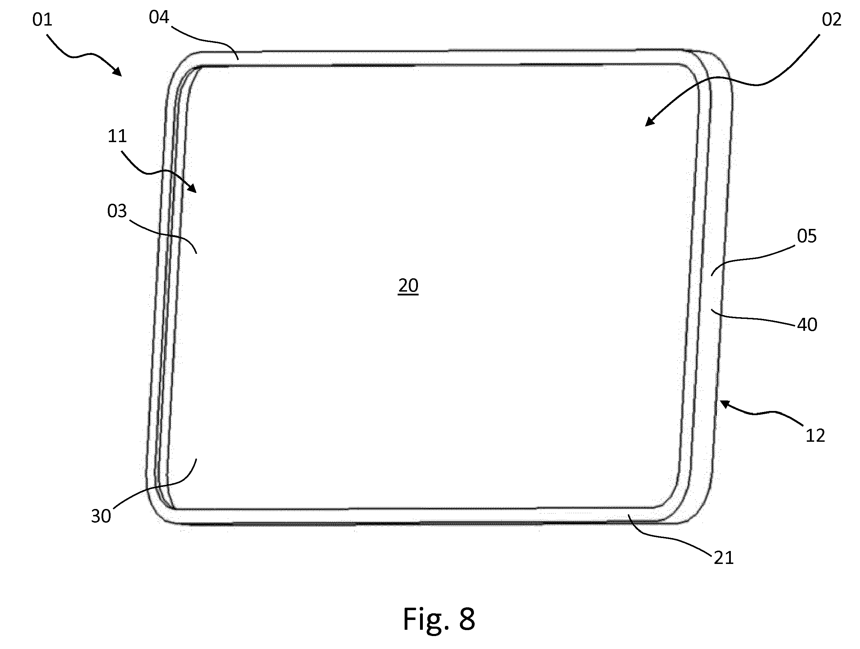

Eine in Fig. 1, Fig. 2, Fig. 3, Fig. 4, Fig. 5, Fig. 6, Fig. 7, Fig. 8 ganz oder in Teilen dargestellte Leuchteinheit 01 umfasst:
- mindestens eine OLED 02 mit einer ersten, vorder- und rückseitigen Verkapselung 03, sowie
- eine zweite Verkapselung 04 zumindest an den die Vorderseite 11 und Rückseite 12 der mit der ersten Verkapselung 03 versehenen mindestens einen OLED 02 miteinander verbindenden Schmalseiten 05.

Die kurz auch als Zusatzverkapselung bezeichnete zweite Verkapselung 04 ist demnach in jedem Fall entlang den von Vorderseite 11 und Rückseite 12 miteinander verbindenden Schmalseiten 05 gebildeten, die Vorderseite 11 und die Rückseite 12 miteinander verbindenden schmalseitigen Rändern und damit an den dort befindlichen Schwachstellen der ersten Verkapselung 03 vorgesehen.

Um dem Einfluss von Diffusionsprozessen durch die Verkapselung hindurch sowie Schad- und Schwachstellen in der Verkapselung zu begegnen, sieht die Erfindung eine zusätzliche, eine bestehende erste Verkapselung 03 zumindest teilweise, vorzugsweise zumindest an deren Schwachstellen umgebende, kurz als Zusatzverkapselung bezeichnete zweite Verkapselung 04 vor.

Die zweite Verkapselung 04 bildet dabei eine Zusatzverkapselung der mindestens einen mit der ersten Verkapselung 03 versehenen OLED 02. Die Erfindung kann demnach durch eine OLED 02 mit einer ersten Verkapselung 03 sowie mit einer durch eine zumindest an den Schmalseiten 05 vorgesehene zweite Verkapselung 04 gebildete Zusatzverkapselung verwirklicht sein.

Bevorzugt umfasst die erste Verkapselung 03 vorder- und rückseitige Schichten 30 mit hohem Wasserdampfdiffusionswiderstand.

Bei der ersten Verkapselung 03 handelt es sich hiernach um vorder- und rückseitige Schichten 30, beispielsweise Dünnglas-Schichten, Glasplättchen, die in einem um die durch die mindestens eine Emitterschicht gebildete Leuchtfläche 20 der OLED 02 umlaufenden Randbereich 21 miteinander verbunden sein können, beispielsweise aneinander anhaften oder miteinander verklebt sein können.

Aufgrund der flächigen Struktur der Dünnglas-Schicht ist eine entsprechend wirksame erste Verkapselung 03 nur vorder- und rückseitig möglich. Die Vorderseite 11 und Rückseite 12 verbindenden Schmalseiten 05 bleiben Schwachstellen der ersten Verkapselung 03.

Die zweite Verkapselung 04 umfasst bevorzugt eine oder mehrere metallische Schichten 40.

Die zweite Verkapselung 04 kann beispielsweise durch Sputtern oder Bedampfen aufgebracht sein.

Die zweite Verkapselung 04 besteht demnach bevorzugt aus einer oder mehreren metallischen Schichten 40, die beispielsweise durch Sputtern oder Bedampfen aufgebracht sein können.

Bevorzugt umfasst die erste Verkapselung 03 zumindest auf der zur Lichtabstrahlung vorgesehenen Vorderseite 11 ein Glasplättchen als vorderseitige Schicht 30 mit hohem Wasserdampfdiffusionswiderstand. In diesem Fall sieht die zweite Verkapselung 04 eine Beschichtung:
- eines um das Glasplättchen umlaufenden Randbereichs 21,
- der die Vorderseite 11 und die Rückseite 12 der die OLED beherbergenden ersten Verkapselung 03 verbindenden Schmalseiten 05, sowie
- der Rückseite 12
vor.

OLEDs 02 für Fahrzeuganwendungen weisen wegen der hohen Sperrwirkung gegen Wasser bevorzugt Glas als Substratmaterial auf. Da Glas eine sehr gute Sperre gegen eindringendes Wasser ist, werden sämtliche Schichten für die OLED 02 hierauf aufgebracht.

Der auch als Dampfsperrwert bezeichnete Wasserdampfdiffusionswiderstand drückt aus, wie stark ein Werkstoff die Ausbreitung von Wasserdampf durch Diffusion durch den Werkstoff hindurch verhindert. Er wird mittels der Wasserdampfdiffusionswiderstandszahl angegeben.

Glas hat ebenso wie Metalle einen sehr hohen Wasserdampfdiffusionswiderstand.

Demgegenüber weisen umgangssprachlich als Kunststoffe bezeichnete Polymere eine relativ hohe Wasserdampfdurchlässigkeit auf, d. h. sie haben eine geringe Sperrwirkung gegenüber Wasser, Wasserdampf. Nachdem Metalle für elektromagnetische Wellen im für das menschliche Auge sichtbaren Teil des Spektrums elektromagnetischer Wellen weitgehend intransparent sind, wird bevorzugt Glas als Substratmaterial für OLEDs 02 verwendet. Eine Eigenschaft, die ebenfalls für die Verwendung von Glas anstelle von Metallen als Substrat spricht ist, dass die Oberfläche von Glas mit einer geringeren Rauheit hergestellt werden kann, was für die dünnen Schichten, die bei einer OLED 02 darauf aufgebracht werden, wichtig ist, um eine gleichmäßige Schichtdicke, sowie einen planen und parallelen Schichtverlauf zu erhalten.

Auf der der Rückseite 12 zugewandten, gegenüberliegenden Außenseite der OLED 02 kann durch ein Glasplättchen als rückseitige Schicht 30 mit hohem Wasserdampfdiffusionswiderstand ebenfalls ein Glasdeckel aufgebracht sein. Die dazwischenliegenden Schichten der OLED 02, insbesondere die organischen Schichten, haben eine Schichtdicke von nur einigen 100nm bis hin zu wenigen µm. Folglich ist die Schwachstelle für eindringende Feuchtigkeit in der Hauptsache der Bereich zwischen den zwei Glasflächenrändern. Dieser Bereich wird vorzugsweise mit entsprechend gutem Material, insbesondere Kleber, versehen, so dass die zwei Glasplättchen in dem Bereich zwischen den zwei Glasflächenrändern aufeinander kleben und die innenliegenden Schichten relativ gut gegen Wasser und andere für die Schichten schädliche Stoffe geschützt sind, wie etwa Sauerstoff, Schwefelverbindungen. Dennoch ist dieser Bereich für eindringendes Wasser die Schwachstelle des OLED-Aufbaus.

Die erste Verkapselung 03 kann demnach zusätzlich zu einem Glasplättchen als vorderseitige Schicht 30 mit hohem Wasserdampfdiffusionswiderstand auf der zur Lichtabstrahlung vorgesehenen Vorderseite 11 der OLED 02 ein Glasplättchen als rückseitige Schicht 30 mit hohem Wasserdampfdiffusionswiderstand auf der der Vorderseite 11 abgewandten, durch die Schichten der OLED 02 von der Vorderseite 11 getrennten, gegenüberliegenden Rückseite 12 umfassen. In diesem Fall sieht die zweite Verkapselung 04 ebenfalls eine Beschichtung:
- eines um das Glasplättchen umlaufenden Randbereichs 21,
- der die Vorderseite 11 und die Rückseite 12 der die OLED beherbergenden ersten Verkapselung 03 verbindenden Schmalseiten 05, sowie
- der Rückseite 12
vor.

Die eine oder mehreren OLEDs 02 der Leuchteinheit 01 können beispielsweise ein Glasplättchen mit aufgebrachter Indium-Zinn-Oxid (ITO; Indium Tin Oxide) Schicht als Substrat, hierauf aufgebrachten organischen und weiteren Schichten, insbesondere Dünnschichtverkapselung (TFE; Thin Film Encapsulation) und Hartschicht zum Schutz der TFE und hierauf eine aufgeklebte und/oder auflaminierte Aluminiumschicht beziehungsweise Alufolie umfassen.

Die Alufolie dient der besseren Wärmeableitung von der OLED 02 weg. Diese vermeidet einen Wärmestau an der OLED 02. Darüber hinaus dient die Alufolie einer besseren Wärmeverteilung an der OLED 02. Durch die gleichmäßige Verteilung der Wärme an der OLED 02 werden so genannte Hot Spots vermieden und dadurch ungleichmäßige Alterungserscheinungen aufgrund unterschiedlicher Temperatureinflüsse verringert.

Eine ungleichmäßige Alterungserscheinung führt zu Inhomogenitäten der Leuchtdichten innerhalb einer durch die von der mindestens einen Emitterschicht der OLED 02 eingenommenen Leuchtfläche 20 und/oder zu einer höheren Wahrscheinlichkeit einer Beschädigung der OLED 02, beispielsweise einem Teilausfall und/oder Frühausfall der OLED 02 während deren Betriebs. Auch kann dies beim Einsatz von mehreren OLEDs 02 und/oder Leuchteinheiten 01 in einer Fahrzeugleuchte aufgrund einer dort herrschenden, nicht gleichmäßigenen Wärmeverteilung, zu sichtbaren Leuchtdichteunterschieden zwischen den OLEDs 02 führen.

Die Alufolie kann alternativ oder zusätzlich auch außen auf ein rückseitiges, zweites Glasplättchen der ersten Verkapselung 03 aufgebracht werden.

Die Beschichtung der zweiten Verkapselung 04 kann die Funktion einer beispielsweise metallischen Schicht zur Wärmespreizung übernehmen, wodurch auf eine entsprechende metallische Schicht in der OLED 02 verzichtet werden kann.

Zur elektrischen Kontaktierung und/oder als elektrische Kontaktierung der wenigstens einen OLED 02 kann die Leuchteinheit 01 mit mindestens einem elektrischen Anschluss 06 ausgestattet sein.

Der mindestens eine elektrische Anschluss 06 der Leuchteinheit 01 beziehungsweise der mindestens einen OLED 02 der Leuchteinheit 01 kann an einer Schmalseite 05 zwischen der ersten, vorder- und rückseitigen Verkapselung 03 durch die zweite Verkapselung 04 hindurch geführt sein.

Besonders bevorzugt umfasst der elektrische Anschluss 06 eine so genannte, auch als Leiterbahnflexfolie bezeichnete, biegsame, beispielsweise elastisch oder biegeschlaff verformbar ausgeführte Flexplatine 60.

Flexplatinen 60 erlauben eine einfache elektrische Kontaktierung von OLEDs 02 beispielsweise durch Löten oder vermittels Leitkleber (ACF; Anisotropic conductive film), wobei die Flexplatine 60 eine erforderliche Flexibilität zwischen dem an der Flexplatine 60 vorgesehenen elektrischen Anschluss einer OLED 02 beispielsweise an eine Stromversorgung und der elektrischen Verbindung zwischen Flexplatine 60 und OLED 02 sicherstellt.

Bei der erfindungsgemäßen Leuchteinheit 01 ist vorgesehen, OLEDs 02 mit einer außen angebrachten, beispielsweise durch eine Beschichtung und/oder Bedampfung hergestellte Zusatzverkapselung beziehungsweise zweiten Verkapselung 04 gegen eindringende Schadstoffe, insbesondere Feuchtigkeit und auch Sauerstoff und/oder Schwefelverbindungen, zu versiegeln. Die Zusatzverkapselung umfasst dabei bevorzugt eine oder mehreren metallischen Schichten 40.

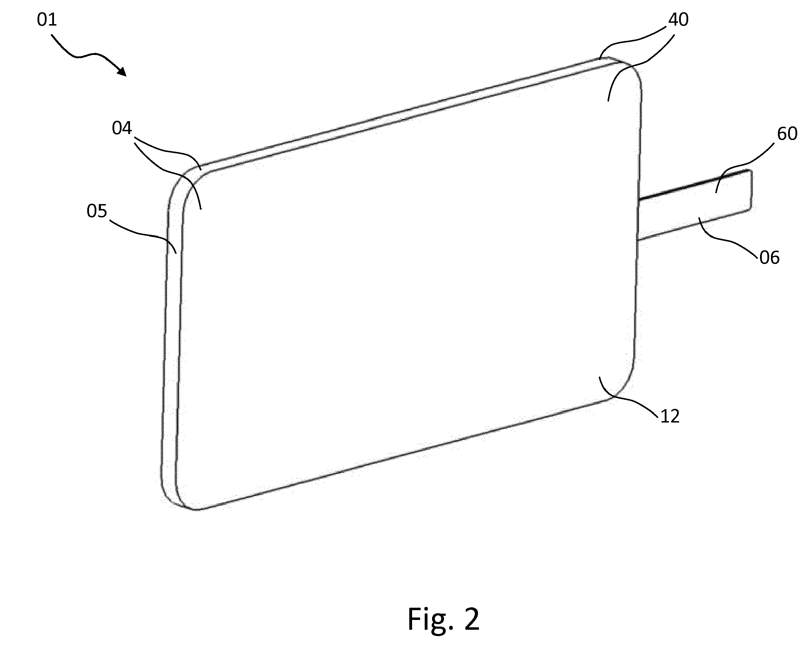

Auch kann die Zusatz- beziehungsweise zweite Versiegelung 04 vollflächig auf der Rückseite 12 angebracht werden, wie dies in Fig. 2 dargestellt ist.

Dadurch kann bei entsprechender Auslegung auch eine bei der Herstellung der OLED 02 zusätzlich aufgebrachte Alufolie/Alubedampfung als Heatspreader entfallen, da diese Funktion auch von der aufgebrachten metallischen Schicht 40 übernommen werden kann. Es ist aber auch eine Kombination einer bei der Herstellung der OLED 02 zusätzlich aufgebrachten Alufolie/Alubedampfung als Heatspreader mit einer metallischen Schicht 40 der zweiten Verkapselung 04 möglich, beispielsweise wenn die Beschichtungsdicke der metallischen Schicht 40 allein zu klein wäre für eine gute Wärmeverteilung an der OLED 02. Das spart Kosten und vereinfacht den OLED-Herstellungsprozess.

Darüber hinaus ist es so auch möglich, den Wirkungsgrad der OLED 02 zu erhöhen, da die metallische Schicht 40, vorzugsweise Aluminium, gut spiegelnd ist. Da die organische Licht abstrahlende Emitterschicht in alle Richtungen Licht abgibt beziehungsweise abstrahlt, wird derjenige Anteil des abgestrahlten Lichts, welcher in Richtung der Alubedampfung abgegeben wird, zurück reflektiert und zu einem Teil wieder an der Vorderseite 11 ausgekoppelt. Dieser Teil des Lichts würde sonst nicht zur Abstrahlung an der Vorderseite 11 oder zumindest nicht in diesem Maße beitragen können.

Die Aufbringung der durch eine zumindest seitliche Beschichtung und/oder Bedampfung hergestellten zweiten Verkapselung 04 an den die Vorderseite 11 und die Rückseite 12 verbindenden Schmalseiten 05 der OLED 02 führt außerdem dazu, dass der seitliche Rand der OLED 02 nicht mehr leuchtet. Die Glasflächen einer OLED 02 verhalten sich ähnlich einem Lichtleiter, daher tritt ein Teil des von einer OLED 02 abgegebenen Lichts an den seitlichen Kanten der OLEDs 02 aus. Dies kann erwünscht sein oder aber auch nicht erwünscht sein. Aufgrund geometrischer Bedingungen und/oder Designanforderungen kann es nachteilig sein, dass dieser Rand leuchtet. Insbesondere in Fahrzeuganwendungen kann dies sogar unzulässig sein, beispielsweise in Verbindung mit der Erfüllung einer Lichtfunktion mit einer zugehörigen Lichtverteilung, die eine generelle Abgabe von Licht innerhalb bestimmter Raumwinkelbereiche verbietet, oder die eine Abgabe von Licht einer bestimmten Wellenlänge innerhalb bestimmter Raumwinkelbereiche verbietet. Ein Beispiel hierfür ist eine Lichtverteilung bei Fahrzeuganwendungen, welche die Abgabe roten Lichts nach vorne generell verbietet.

Nach gesetzlichen Regelungen, beispielsweise der Vorgaben des Verbands der Automobilingenieure (SAE; Society of Automotive Engineers), ist es untersagt in einen gewissen Winkelbereich rotes Licht, welches an den Leuchten insbesondere am Heck austritt, erkennen zu können. Hierfür sind auch gesetzliche Maximalwerte festgelegt und andere Vorgaben. Der Zweck der Regelung ist folgendes: Hierdurch soll vor allem klar erkennbar sein, ob sich ein Fahrzeug eines Verkehrteilnehmers auf einen zubewegt (weiße Scheinwerfer) oder vor einem fährt (rote Heckleuchten).

Diese Regelungen können auch mit den Vorgaben für die Lichterführung von Schiffen verglichen werden, die eine in mehrere Sektoren unterschiedlicher Farben gegliederte Lichterführung vorschreibt, um nachts zumindest eindeutig erkennen zu können, ob ein anderes Schiff einen Kollisionskurs zum Kurs des eigenen Schiffes steuert, oder ob eine gefahrfreie Passage erfolgt.

Mit Hilfe der Erfindung kann dies einfach und zugleich höchst wirkungsvoll verhindert werden, da die zweite Versiegelung 04 bevorzugt durch eine oder mehrere lichtundurchlässige metallische Schichten 40 hergestellt ist, welche ausschließlich die Leuchtfläche 20 freihält und ansonsten die OLED 02 bevorzugt allseitig umgibt.

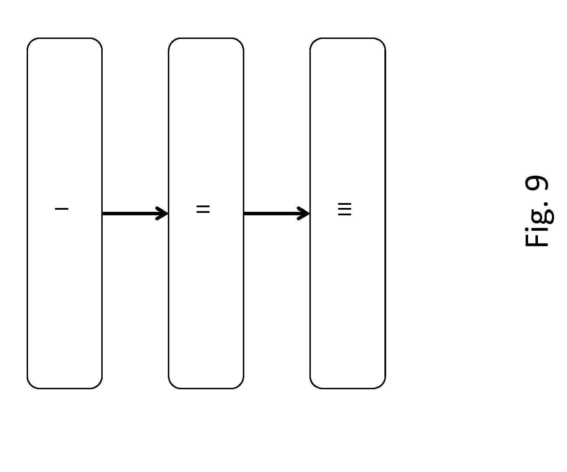

Eine zuvor beschriebene Leuchteinheit 01 kann durch ein nachfolgend beschriebenes und in Fig. 9 in seinem Ablauf dargestelltes Verfahren hergestellt werden.

Ein solches Verfahren sieht in einem ersten Verfahrensschritt I eine Bereitstellung mindestens einer OLED 02 mit einer ersten, vorder- und rückseitigen Verkapselung 03 vor.

Im Anschluss an den ersten Verfahrensschritt I sieht das Verfahren in einem zweiten Verfahrensschritt II eine Schablonierung der OLED 02 unter Maskierung zumindest eines eine in ihrer Ausdehnung der von einer Emitterschicht der OLED 02 eingenommenen Fläche entsprechenden Leuchtfläche 20 auf der zur Lichtabstrahlung vorgesehenen Vorderseite 11 der OLED einnehmenden Teils der ersten Verkapselung 03 vor.

Im Anschluss an den zweiten Verfahrensschritt II sieht das Verfahren in einem dritten Verfahrensschritt III ein Aufbringen der zweiten Verkapselung 04 unter Freilassung des bei der Schablonierung maskierten Teils der ersten Verkapselung 03 von der zweiten Verkapselung 04 vor.

Besonders bevorzugt kann das Aufbringen der zweiten Verkapselung 04 durch Beschichtung und/oder Bedampfen und/oder Sputtern erfolgen.

Dabei wird die zweite Verkapselung 04 bevorzugt durch Aufbringen einer metallischen Schicht 40, vorzugsweise durch Beschichtung und/oder Bedampfen und/oder Sputtern, hergestellt.

Bei der Schablonierung kann vorgesehen werden, Teile der Leuchtfläche 20 nicht zu maskieren, beispielsweise um einen Teil 22 der Leuchtfläche 20 mittels einer dort vorzunehmenden, beispielsweise farbigen Beschichtung farblich hervorzuheben und/oder in dem Teil 22 der Leuchtfläche eine Lichtabstrahlung zu unterbinden.

Der zweite Gegenstand der Erfindung sieht demnach vor die eine oder mehreren OLEDs 02 schabloniert zu beschichten und/oder zu bedampfen. Hierdurch wird eine in Fig. 1 dargestellte Versiegelung als Zusatzverkapselung erhalten. An der Vorderseite 11 wird nicht oder nicht vollflächig beschichtet und/oder bedampft, da dort die Lichtauskopplung erfolgen soll. Daher soll mindestens ein Teil vor der Leuchtfläche 20 frei bleiben. Als Material eignen sich insbesondere Wasserundurchlässige, zugleich jedoch hochgradig wasserdichteMaterialien, allem voran Metalle, wie etwa Aluminium oder auch Gold. Aluminium wird bei Fahrzeugleuchten bislang zur Metallisierung von Reflektoren eingesetzt. Daher sind diese Verfahren, wie etwa das Bedampfen sowie Sputtern auch bei der Herstellung von Fahrzeugleuchten verfügbar. Darüber hinaus ist so ein sicherer Umgang sowie ausreichend vorhandene Erfahrungen damit gewährleistet.

Durch die Schablonierung werden insbesondere die Vorderseite 11 und Rückseite 12 verbindende Schmalseiten 05 und damit der Bereich, der als Schwachstelle insbesondere zwischen den Glas-Glas- oder Glas-Aluminium-Außenflächen der OLED 02 besteht mit der bevorzugt als metallische Schicht 40 ausgeführten zweiten Verkapselung 04 versiegelt.

Durch Beschichten und/oder Aufdampfen von Gold kann auch eine Leuchteinheit 01 mit einem sehr hochwertigen Erscheinungsbild verwirklicht werden. Beispielsweise kann dies für Designerleuchten auch in Heckleuchten für Fahrzeuge eingesetzt werden, beispielsweise in Verbindung mit einer klaren Lichtscheibe.

Vorteile gegenüber dem Stand der Technik sind eine Verbesserung der Kapselung organischer Leuchtdioden gegen das Eindringen schädlichen Wasserdampfs und Sauerstoffs einhergehend mit einer Erhöhung deren Lebensdauer insbesondere bei Fahrzeuganwendungen.

Sowohl die Leuchteinheit 01, als auch das zu deren Herstellung beschriebene Verfahren können alternativ oder zusätzlich einzelne oder eine Kombination mehrerer einleitend in Verbindung mit dem Stand der Technik und/oder in einem oder mehreren der zum Stand der Technik erwähnten Dokumente und/oder in der vorangehenden Beschreibung oder in den Ansprüchen erwähnte Merkmale aufweisen.

Darüber hinaus kann die Leuchteinheit 01 einzelne oder eine Kombination zuvor in Verbindung mit dem Verfahren beschriebene Merkmale aufweisen, ebenso wie das Verfahren einzelne oder eine Kombination mehrerer zuvor in Verbindung mit der Leuchteinheit beschriebene Merkmale aufweisen und/oder verwirklichen kann.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Ansprüchen beinhaltet, auch wenn dieses Merkmal oder diese Kombination selbst nicht explizit in den Ansprüchen oder Ausführungsbeispielen angegeben ist.

Die Erfindung ist insbesondere im Bereich der Herstellung von Fahrzeugleuchten, insbesondere Kraftfahrzeugleuchten gewerblich anwendbar.

Die Erfindung wurde unter Bezugnahme auf bevorzugte Ausführungsformen beschrieben. Es ist jedoch für einen Fachmann vorstellbar, dass Abwandlungen oder Änderungen der Erfindung gemacht werden können, ohne dabei den Schutzbereich der nachstehenden Ansprüche zu verlassen.

### Bezugszeichenliste

- 01: Leuchteinheit
- 02: OLED
- 03: erste Verkapselung
- 04: zweite Verkapselung
- 05: Schmalseite
- 06: elektrischer Anschluss

- 11: Vorderseite
- 12: Rückseite

- 20: Leuchtfläche
- 21: Randbereich
- 22: Teil

- 30: Schicht (Glas)

- 40: Schicht (metallisch)

- 60: Flexplatine

- I: Verfahrensschritt
- II: Verfahrensschritt
- III: Verfahrensschritt

## Patentansprüche

1. Leuchteinheit (01) mit mindestens einer OLED (02) mit einer ersten, vorder- und rückseitigen Verkapselung (03), **gekennzeichnet durch** eine zweite Verkapselung (04) zumindest an den Vorderseite (11) und Rückseite (12) miteinander verbindenden Schmalseiten (05).

2. Leuchteinheit nach Anspruch 1, wobei die erste Verkapselung (03) vorder- und rückseitige Schichten (30) umfasst.

3. Leuchteinheit nach Anspruch 1 oder 2, wobei die zweite Verkapselung (04) eine oder mehrere metallische Schichten (40) umfasst.

4. Leuchteinheit nach Anspruch 1, 2 oder 3, wobei die zweite Verkapselung (04) durch Sputtern oder Bedampfen aufgebracht ist.

5. Leuchteinheit nach einem der Ansprüche 1 bis 4, wobei die erste Verkapselung (03) ein Glasplättchen zumindest auf der zur Lichtabstrahlung vorgesehenen Vorderseite (11) und die zweite Verkapselung (04) eine Beschichtung:
- eines um das Glasplättchen umlaufenden Randbereichs,
- der die Vorderseite (11) und die Rückseite (12) verbindenden Schmalseiten (05), sowie
- der Rückseite (12)
umfasst.

6. Leuchteinheit nach einem der Ansprüche 1 bis 4, wobei die erste Verkapselung (03) jeweils ein Glasplättchen auf der zur Lichtabstrahlung vorgesehenen Vorderseite (11) und auf der Rückseite (12) und die zweite Verkapselung (04) eine Beschichtung:
- eines um das Glasplättchen der Vorderseite (11) umlaufenden Randbereichs,
- der die Vorderseite (11) und die Rückseite (12) verbindenden Schmalseiten (05), sowie
- der Rückseite (12)
umfasst.

7. Leuchteinheit nach einem der voranstehenden Ansprüche, wobei die eine oder mehreren OLEDs (02) der Leuchteinheit ein Glasplättchen mit aufgebrachter Indium-Zinn-Oxid (ITO; Indium Tin Oxide) Schicht als Substrat, hierauf aufgebrachten organischen und weiteren Schichten, insbesondere Dünnschichtverkapselung (TFE; Thin Film Encapsulation) und Hartschicht zum Schutz der TFE und hierauf eine aufgeklebte und/oder auflaminierte Aluminiumschicht beziehungsweise Alufolie umfassen.

8. Leuchteinheit nach Anspruch 7, wobei die Alufolie außen auf ein Glasplättchen der ersten Verkapselung (03) aufgebracht ist.

9. Leuchteinheit nach einem der voranstehenden Ansprüche, wobei die zweite Verkapselung (04) die Funktion einer Schicht zur Wärmespreizung übernimmt.

10. Leuchteinheit nach einem der voranstehenden Ansprüche, wobei die zweite Verkapselung (04) die Rückseite (12) vollständig einnimmt.

11. Leuchteinheit nach einem der voranstehenden Ansprüche, wobei wenigstens ein elektrischer Anschluss (06) an einer Schmalseite (05) zwischen der ersten, vorder- und rückseitigen Verkapselung (03) durch die zweite Verkapselung (04) hindurch geführt ist.

12. Leuchteinheit nach Anspruch 11, wobei der elektrische Anschluss (06) eine Flexplatine (60) umfasst.

13. Verfahren zur Herstellung einer Leuchteinheit (01) nach einem der voranstehenden Ansprüche, umfassend die Verfahrensschritte:
- Bereitstellung einer OLED (02) mit einer ersten, vorder- und rückseitigen Verkapselung (03),
- Schablonierung der OLED (02) unter Maskierung zumindest eines Teils der ersten Verkapselung (03), und
- Aufbringen der zweiten Verkapselung (04) unter Freilassung des bei der Schablonierung maskierten Teils der ersten Verkapselung (03) von der zweiten Verkapselung (04).

14. Verfahren nach Anspruch 13, wobei das Aufbringen der zweiten Verkapselung (04) durch Beschichtung und/oder Bedampfen und/oder Sputtern erfolgt.
